# EUROPEAN PATENT APPLICATION

(11) **EP 4 782 865 A1**
(43) Date of publication of application: **29.07.2026**
(21) Application number: 26154838.2
(22) Date of filing: 28.01.2026
(51) Int. Cl.: G01R 33/48, G01R 33/56, G01R 33/561, G01R 33/565

(54) **MAGNETIC RESONANCE IMAGING APPARATUS, IMAGE PROCESSING APPARATUS, IMAGE PROCESSING METHOD, AND PROGRAM**

(30) Priority: 28.01.2025 JP 2025012498
(71) Applicant: FUJIFILM Corporation, Tokyo 106-8620 (JP)
(72) Inventor: SUZUKI, Atsuro, Tokyo, 1068620 (JP); SHIRAI, Toru, Tokyo, 1068620 (JP); YOKOSAWA, Suguru, Tokyo, 1068620 (JP); SHOJI, Hiroki, Tokyo, 1068620 (JP); HIRAKAWA, Yuya, Tokyo, 1068620 (JP)
(74) Representative: Dehns Germany Partnerschaft mbB

(57) **Abstract**

Provided are a magnetic resonance that can obtain a reconstruction image in which resolution of an unmeasured region is improved while an increase in noise in a measurement region is suppressed. A magnetic resonance imaging apparatus (10) according to the present disclosure estimates a second reconstruction image by inputting a first reconstruction image obtained by reconstructing data of a k-space including partial measurement data of a measurement region to a trained model, and generates a fourth reconstruction image by reconstructing the data of the k-space including first measurement region data of the measurement region of the k-space obtained by performing a Fourier transform on the second reconstruction image and first unmeasured region data of the unmeasured region of the k-space obtained by performing a Fourier transform on a third reconstruction image obtained by performing edge enhancement filter processing on the second reconstruction image.

## Description

### BACKGROUND OF THE INVENTION

### 1. Field of the Invention

The present disclosure relates to a magnetic resonance imaging apparatus, an image processing apparatus, an image processing method, and a program, and particularly relates to a signal processing technique for generating a reconstruction image from partial k-space data collected in an asymmetrical region in a k-space.

### 2. Description of the Related Art

In magnetic resonance imaging (MRI) imaging using an MRI apparatus, in order to reduce an imaging time, a half-Fourier method is used in which a k-space corresponding to a matrix size of a field of view (FOV) is partially asymmetrically measured, and data of an unmeasured region is estimated from data of measured values collected from a measurement region. The half-Fourier method is a method of estimating data of an unmeasured region from data of a measurement region by using Hermitian conjugate of the k-space to generate a reconstruction image. In this method, as the unmeasured region in the k-space increases, the degradation of image quality of the reconstruction image increases.

In order to solve such an issue, in US2022/0198725A, image quality of an image generated from partial measurement data is improved by using a convolutional neural network (CNN) trained through machine learning using, as training data, a pair of a reconstruction image of full measurement data collected by measuring an entire region of a matrix of the k-space and a reconstruction image of partial measurement data collected in an asymmetrical measurement region set in the k-space.

### SUMMARY OF THE INVENTION

In the method using the CNN described in US2022/0198725A, the data of the unmeasured region is estimated from the measurement region, but it is difficult to completely restore even the radio frequency component, and the resolution is degraded. In addition, in a case in which the edge is simply enhanced using the edge enhancement filter, the noise of the measurement region is also increased.

The present invention has been made in view of such circumstances, and an object of the present invention is to provide a magnetic resonance imaging apparatus, an image processing apparatus, an image processing method, and a program that can obtain a reconstruction image in which resolution of an unmeasured region is improved while an increase in noise in a measurement region is suppressed.

In order to achieve the above object, a first aspect of the present disclosure relates to a magnetic resonance imaging apparatus comprising: a processor that converts data acquired by imaging a subject into an image, in which the processor acquires partial measurement data of an asymmetrical measurement region of a k-space, reconstructs data of the k-space including the partial measurement data to generate a first reconstruction image of a real space, estimates a second reconstruction image by inputting the first reconstruction image to a trained model that has been trained to receive an input of an input image in which the data of the k-space including data of the measurement region is reconstructed and output an estimation image in which data of an unmeasured region other than the measurement region is estimated, acquires first measurement region data of the measurement region of the k-space obtained by performing a Fourier transform on the second reconstruction image, generates a third reconstruction image obtained by performing edge enhancement filter processing on the second reconstruction image, acquires first unmeasured region data of the unmeasured region of the k-space obtained by performing a Fourier transform on the third reconstruction image, and generates a fourth reconstruction image by reconstructing the data of the k-space including the first measurement region data and the first unmeasured region data.

A first embodiment of the present disclosure relates to the magnetic resonance imaging apparatus according to the first aspect, in which it is preferable that the processor acquires first adjacent region data corresponding to an adjacent region that is adjacent to the measurement region and extends a predetermined distance from the measurement region in second unmeasured region data of the unmeasured region of the k-space obtained by performing a Fourier transform on the second reconstruction image, acquires second adjacent region data corresponding to the adjacent region in the first unmeasured region data, generates third adjacent region data from the first adjacent region data of which a weight is gradually decreased as a distance from the measurement region increases and the second adjacent region data of which a weight is gradually increased as the distance from the measurement region increases, and generates the fourth reconstruction image by reconstructing the data of the k-space including the first measurement region data, the third adjacent region data, and the first unmeasured region data other than the adjacent region.

A second embodiment of the present disclosure relates to the magnetic resonance imaging apparatus according to the first embodiment, in which it is preferable that the processor multiplies the first adjacent region data by a first window function having a value of 1 at a position adjacent to the measurement region and a value of 0 at a position at the predetermined distance from the measurement region, multiplies the second adjacent region data by a second window function having a value of 0 at a position adjacent to the measurement region and a value of 1 at a position at the predetermined distance from the measurement region, and generates the third adjacent region data by adding the multiplied first adjacent region data and the multiplied second adjacent region data.

A third embodiment of the present disclosure relates to the magnetic resonance imaging apparatus according to the second embodiment, in which it is preferable that the first window function and the second window function are each a Hanning window.

A fourth embodiment of the present disclosure relates to the magnetic resonance imaging apparatus according to any one of the first aspect or first to third embodiments, in which it is preferable that the processor acquires strength of the edge enhancement filter processing, and generates the third reconstruction image obtained by performing the edge enhancement filter processing with the acquired strength.

A fifth embodiment of the present disclosure relates to the magnetic resonance imaging apparatus according to the fourth embodiment, in which it is preferable that the processor acquires the strength based on an average value of absolute values of the data of the measurement region that is symmetrical to the unmeasured region of the k-space in the first measurement region data and an average value of absolute values of the first unmeasured region data.

A sixth embodiment of the present disclosure relates to the magnetic resonance imaging apparatus according to the fourth embodiment, in which it is preferable that the processor receives an input of the strength from an operator.

A ninth embodiment of the present disclosure relates to the magnetic resonance imaging apparatus according to any one of the first aspect or first to sixth embodiments, in which it is preferable that the trained model is a trained model that has been trained through machine learning to receive the input of the input image in which the data of the k-space consisting of the measurement region filled with input measurement region data and the unmeasured region filled with zero data is reconstructed, and estimate and output the estimated reconstruction image of the real space reconstructed from the data of the k-space consisting of the measurement region filled with estimated measurement region data and the unmeasured region filled with estimated unmeasured region data.

An eighth embodiment of the present disclosure relates to the magnetic resonance imaging apparatus according to any one of the first aspect or first to sixth embodiments, in which it is preferable that the trained model is a trained model that has been trained through machine learning to receive the input of the input image in which the data of the k-space consisting of the measurement region filled with input measurement region data and the unmeasured region filled with zero data is reconstructed, and estimate and output an estimated residual image indicating a residual between the input image and the estimated reconstruction image of the real space reconstructed from the data of the k-space consisting of the measurement region filled with estimated measurement region data and the unmeasured region filled with estimated unmeasured region data.

In order to achieve the above object, a second aspect of the present disclosure relates to an image processing apparatus comprising: a processor that converts data acquired by imaging a subject into an image, in which the processor acquires partial measurement data of an asymmetrical measurement region of a k-space, reconstructs data of the k-space including the partial measurement data to generate a first reconstruction image of a real space, estimates a second reconstruction image by inputting the first reconstruction image to a trained model that has been trained to receive an input of an input image in which the data of the k-space including data of the measurement region is reconstructed and output an estimation image in which data of an unmeasured region other than the measurement region is estimated, acquires first measurement region data of the measurement region of the k-space obtained by performing a Fourier transform on the second reconstruction image, generates a third reconstruction image obtained by performing edge enhancement filter processing on the second reconstruction image, acquires first unmeasured region data of the unmeasured region of the k-space obtained by performing a Fourier transform on the third reconstruction image, and generates a fourth reconstruction image by reconstructing the data of the k-space including the first measurement region data and the first unmeasured region data.

In order to achieve the above object, an third aspect of the present disclosure relates to an image processing method executed by a processor that converts data acquired by imaging a subject into an image, the image processing method comprising: acquiring partial measurement data of an asymmetrical measurement region of a k-space; reconstructing data of the k-space including the partial measurement data to generate a first reconstruction image of a real space; estimating a second reconstruction image by inputting the first reconstruction image to a trained model that has been trained to receive an input of an input image in which the data of the k-space including data of the measurement region is reconstructed and output an estimation image in which data of an unmeasured region other than the measurement region is estimated; acquiring first measurement region data of the measurement region of the k-space obtained by performing a Fourier transform on the second reconstruction image; generating a third reconstruction image obtained by performing edge enhancement filter processing on the second reconstruction image; acquiring first unmeasured region data of the unmeasured region of the k-space obtained by performing a Fourier transform on the third reconstruction image; and generating a fourth reconstruction image by reconstructing the data of the k-space including the first measurement region data and the first unmeasured region data.

In order to achieve the above object, a fourth aspect of the present disclosure relates to a program for causing a computer to execute the image processing method according to the third aspect. The present disclosure also includes a non-transitory computer-readable storage medium in which the program according to the fourth aspect is stored.

The image processing apparatus according to the second aspect, the image processing method according to the third aspect, and the program according to the fourth aspect may have the same specific aspects as the magnetic resonance imaging apparatus described above.

According to the aspects of the present invention, it is possible to obtain the reconstruction image in which the resolution of the unmeasured region is improved while the increase in noise in the measurement region is suppressed.

### BRIEF DESCRIPTION OF THE DRAWINGS

FIG. 1 is a diagram illustrating a schematic configuration of an MRI apparatus according to an embodiment of the present disclosure.
FIG. 2 is a diagram illustrating examples of full measurement data of k-space and an MR image reconstructed from the full measurement data.
FIG. 3 is a diagram illustrating examples of each point of data arranged in the k-space and a k-trajectory.
FIG. 4 is a diagram illustrating an example of a data filling method using asymmetric k-space sampling.
FIG. 5 is a conceptual diagram illustrating a method of improving the degradation of image quality of the MR image using a CNN.
FIG. 6 is a diagram illustrating an example of a network structure of the CNN applied as a trained model.
FIG. 7 is a diagram illustrating examples of an input image and an output image of the CNN.
FIG. 8 is a diagram illustrating an example of a method of generating a training image set for training the CNN.
FIG. 9 is a functional block diagram of a processor of a control device.
FIG. 10 is a diagram illustrating the degradation in resolution by a CNN estimation method.
FIG. 11 is a diagram illustrating an image processing method according to a first embodiment.
FIG. 12 is a flowchart illustrating steps of a generation method of an MR image according to the first embodiment.
FIG. 13 is a diagram illustrating the improvement in resolution.
FIG. 14 is a diagram illustrating an image processing method according to a second embodiment.
FIG. 15 is a graph illustrating a Hanning window function.
FIG. 16 is a flowchart illustrating steps of a generation method of an MR image according to the second embodiment.

### DESCRIPTION OF THE PREFERRED EMBODIMENTS

Hereinafter, preferred embodiments of a magnetic resonance imaging apparatus and an operation method of a magnetic resonance imaging apparatus according to an embodiment of the present invention will be described with reference to the accompanying drawings.

### Configuration of Magnetic Resonance Imaging Apparatus

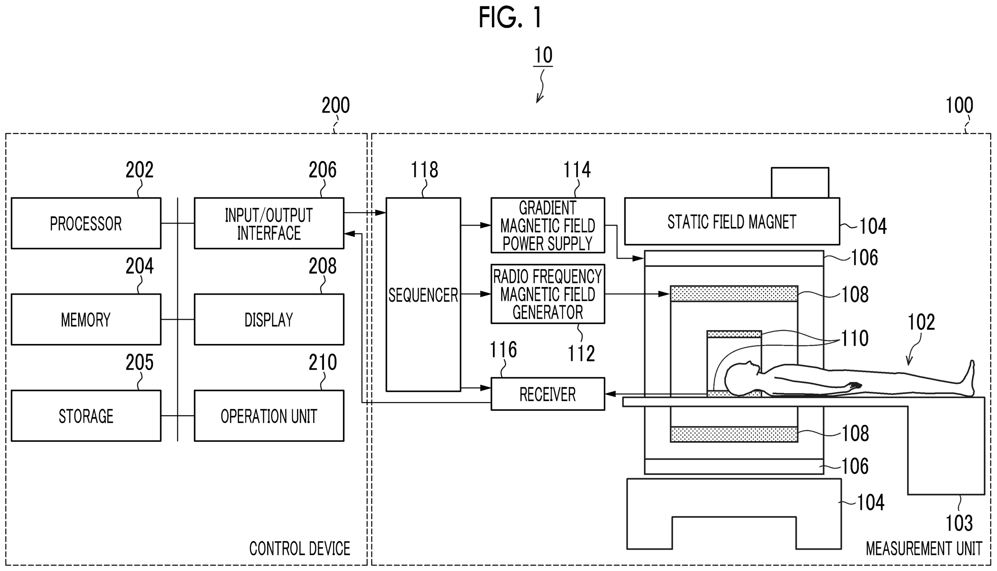

FIG. 1 is a diagram illustrating a schematic configuration of an MRI apparatus 10 according to the embodiment of the present disclosure. The MRI apparatus 10 comprises a measurement unit 100 and a control device 200. The measurement unit 100 comprises a static field magnet 104, a gradient coil 106, a radio frequency (RF) coil 108, a radio frequency magnetic field generator 112, a gradient magnetic field power supply 114, a receive coil 110, a receiver 116, and a sequencer 118.

The measurement unit 100 includes a gantry having a cylindrical imaging space called a bore, and elements such as the static field magnet 104, the gradient coil 106, and the RF coil 108 are disposed in the gantry. A subject 102 is usually placed in the imaging space in the gantry in a state of lying on a bed 103. The bed 103 may be fixed to the gantry or may be a movable dockable bed that is attachable to and detachable from the gantry.

The static field magnet 104 generates a uniform static magnetic field in the imaging space in which the subject 102 is placed. The static field magnet 104 includes a static magnetic field generation source of a permanent magnet type, a normal conduction type, or a superconducting type. The gradient coil 106 generates a gradient magnetic field in the imaging space. The RF coil 108 generates a radio frequency magnetic field that generates a nuclear magnetic resonance (NMR) signal in atomic nuclei of atoms constituting a tissue of the subject 102. The RF coil 108 is also referred to as a transmit coil. The receive coil 110 detects the NMR signal generated from the subject 102. The receive coil 110 is also referred to as an RF probe.

The sequencer 118 transmits control information to the radio frequency magnetic field generator 112 and the gradient magnetic field power supply 114 according to a pulse sequence (imaging sequence). The radio frequency magnetic field generator 112 generates radio frequency current pulses at the Larmor frequency that cause nuclear magnetic resonance based on the control information input from the sequencer 118, and transmits the radio frequency current pulse to the RF coil 108. The RF pulses corresponding to the radio frequency current pulses are transmitted from the RF coil 108 to the subject 102.

The receive coil 110 detects the NMR signal generated by exciting the nuclear spins in the subject 102 by the RF pulses, and transmits the detected NMR signal. The NMR signal is usually collected as a gradient echo or a spin echo, and is referred to as an echo signal herein. The receive coil 110 illustrated in FIG. 1 is a coil that receives the echo signal from the head of the subject 102, but is not limited to the receive coil that receives the echo signal from the head, and a receive coil corresponding to an examination part of the subject 102 such as the chest, the abdomen, the waist, the shoulder, and the hand and foot may be used and appropriately set. Further, there is also a flexible blanket type receive coil that is placed over the chest, the abdomen, and the waist.

The gradient coil 106 is composed of an X-axis gradient coil, a Y-axis gradient coil, and a Z-axis gradient coil that generate gradient magnetic fields Gx, Gy, and Gz in the X-axis direction, the Y-axis direction, and the Z-axis direction of the imaging space, respectively, and generates the gradient magnetic field corresponding to the current supplied from the gradient magnetic field power supply 114 in the imaging space. In the imaging space, an orthogonal tri-axial coordinate system is usually defined such that a direction of a central axis of the gantry 12 is a Z-axis direction, a vertical direction is a Y-axis direction, and a direction orthogonal to both the Z-axis and the Y-axis is an X-axis direction.

The Z-axis gradient coil generates the gradient magnetic field Gz for selecting a slice position and a slice width of a plane of the subject 102 orthogonal to the Z-axis direction. The X-axis gradient coil generates the gradient magnetic field Gx proportional to the position in the X-axis direction as a readout direction (frequency encoding direction) gradient magnetic field during a period in which the echo signal is generated. The Y-axis gradient coil generates the phase encoding direction gradient magnetic field Gy having different intensities for each repetition time (TR).

The sequencer 118 controls each unit to operate at timing and intensity that are programmed in advance. Among the programs, in particular, a program describing the timing and the intensity of the RF pulse, the gradient magnetic fields Gx, Gy, and Gz, and the signal reception is called a pulse sequence.

Various pulse sequences are known depending on the purpose, and for example, a spin echo method and a gradient echo method are known, and various pulse sequences derived from these methods are known. Further, there is echo planar imaging (EPI), which is one of the high-speed imaging methods. In EPI, there are single-shot EPI, in which, during excitation by a single RF pulse, the gradient magnetic field is repeatedly reversed to generate a plurality of gradient echoes and fill k-space (the spatial-frequency domain) with the data required for image reconstruction, and multi-shot EPI, in which k-space is filled with echo-train data obtained over a plurality of shots.

The NMR signal generated from the subject 102 is detected by the receive coil 110, amplified by a preamplifier (not illustrated) in the receive coil 110, and transmitted to the receiver 116.

The receiver 116 includes a quadrature detection circuit, an analog-to-digital (A/D) converter, and other signal processing circuits. In the receiver 116, the amplified NMR signal is subjected to the A/D conversion and required signal processing to generate data. The data generated in this manner is transmitted to the control device 200.

For example, the receiver 116 executes the detection and the A/D conversion of the echo signal detected by the receive coil 110, and transmits two streams of digital data of a real part and an imaginary part to the control device 200. The digital data is also referred to as reception signal data or measurement data.

The sequencer 118 transmits information on the nuclear magnetic resonance frequency (detection reference frequency) that is a reference for quadrature detection performed by the receiver 116, a timing of the A/D conversion (sampling timing in the frequency encoding direction), and the like, and controls the receiver 116.

A reception-side cable (not illustrated) that outputs the NMR signal received by the receive coil 110 is connected to the receive coil 110. Although not illustrated in FIG. 1, a reception-side connector is connected to an end part of the reception-side cable. The reception-side connector is connected to a bed-side connector provided at the bed 103. The bed-side connector is connected to a bed-side cable disposed inside the bed 103, and the bed-side cable is connected to the control device 200.

As a result, the receive coil 110 is communicably connected to the control device 200 and the sequencer 118. The connection between the receive coil 110 and the control device 200 and the sequencer 118 is not limited to a wired connection such as a cable, and an aspect in which the connection is made wirelessly is also possible. In this case, the receive coil 110 or the bed 103 further includes at least an A/D conversion module and a wireless communication module.

The control device 200 controls the measurement unit 100 and performs various calculations such as image reconstruction based on the signal obtained from the measurement unit 100. The control device 200 can be configured by using a computer. The computer applied to the control device 200 may be a personal computer, a workstation, or a server computer.

The control device 200 comprises a processor 202, a memory 204, a storage 205, an input/output interface 206, a display 208, an operation unit 210, and the like as hardware.

The processor 202 includes a central processing unit (CPU). The processor 202 may include a graphics processing unit (GPU). In addition, the processor 202 may include one or a plurality of hardware components of a digital signal processor (DSP), an application-specific integrated circuit (ASIC), a programmable logic device (PLD), and the like.

The processor 202 performs overall control of each unit of the control device 200 and the measurement unit 100, and executes various programs stored in the memory 204 to execute various functions. The processor 202 converts the data obtained by imaging the subject into an image.

The memory 204 is a storage device including a random-access memory (RAM). The memory 204 may include one or more of a flash memory and a read-only memory (ROM). The storage 205 is a storage device including, for example, one or more of a hard disk device, a solid state drive device, and a removable recording medium. The flash memory, the ROM, and the storage 205 are non-volatile storage devices that store an operation system, a program for causing the processor 202 to function as the control device 200, various pulse sequences, a calculation formula used for image reconstruction, parameters, a trained model, an MR image reconstructed by image reconstruction, and the like.

The RAM functions as a work area for processing by the processor 202, and temporarily stores the programs and the like stored in the non-volatile storage device. In addition, the RAM functions as a place for temporarily storing the measurement data that is digital sampling data obtained by processing the echo signal obtained from the measurement unit 100, that is, so-called raw data. A portion (RAM) of the memory 204 may be provided in the processor 202.

The input/output interface 206 includes a communication unit that is connectable to a network, a connection unit that is connectable to an external device, and the like. As the connection unit that is connectable to the external device, a universal serial bus (USB) (USB is a registered trademark), a high-definition multimedia interface (HDMI) (HDMI is a registered trademark), and the like can be applied.

The processor 202 communicates with the device (in the present example, the sequencer 118) and the receiver 116 disposed in the measurement unit 100 via the input/output interface 206 to transmit and receive required information. In addition, a portion of the sequencer 118 may be provided on the control device 200 side.

The display 208 is configured by, for example, a liquid crystal display, an organic electro-luminescence (OEL) display, a projector, or an appropriate combination thereof. Various types of information are displayed on the display 208, in addition to the MR image captured by the MRI apparatus 10. The display 208 is used as a portion of a user interface (UI) in a case of receiving an input from the operation unit 210. The display 208 is not limited to a single display device, and can also be in a multi-display form comprising a plurality of display devices.

The operation unit 210 includes an input device such as a mouse, a keyboard, and the like, and functions as a portion of a GUI that receives the input from an operator by using a display operation window of the display 208. For example, the operation unit 210 and the display 208 function as a GUI for the operator to activate and stop (pause) the measurement unit 100, select the pulse sequence, and input the imaging conditions, the processing conditions, and the like. The operation unit 210 may include an audio input device. Further, the operation unit 210 may be a touch panel type input device that is integrally configured with a display screen of the display 208.

### Relationship between Data of k-Space and Image Data of Real Space

The k-space is a space representing a wave number (spatial frequency) distribution of image data of a real space, and the image data of the real space and the data of the k-space have a relationship in which the image data and the data of the k-space can be converted to each other by a Fourier transform and an inverse Fourier transform. Since the NMR signal is expressed as a Fourier transform of the nuclear magnetization distribution, the NMR signal can be regarded as a signal in wavenumber space (k-space) by converting the variables of resonance frequency and time into position coordinates and wavenumber based on the Larmor equation and a linear gradient magnetic field. That is, the k-space in MRI is understood as a data space that stores the measurement data obtained by digitally sampling the echo signal, and is also referred to as a measurement space.

In general, the k-space, which is a Fourier transform space of the real space, is defined as a three-dimensional k-space by a coordinate system of wave numbers (kx, ky, kz) corresponding to a coordinate system of positions (x, y, z) in the real space, but, here, as a typical example of the MRI, a case will be described in which a two-dimensional image is generated from two-dimensional k-space data by performing frequency encoding and phase encoding in an imaging tomographic plane designated by slice selection using the gradient magnetic field in the Z direction.

The two-dimensional k-space is represented by, for example, a two-dimensional plane in which a kx axis as the horizontal axis is a frequency encoding axis and a ky axis as the vertical axis is a phase encoding axis. The definition of each axis (dimension) is not limited to the above example.

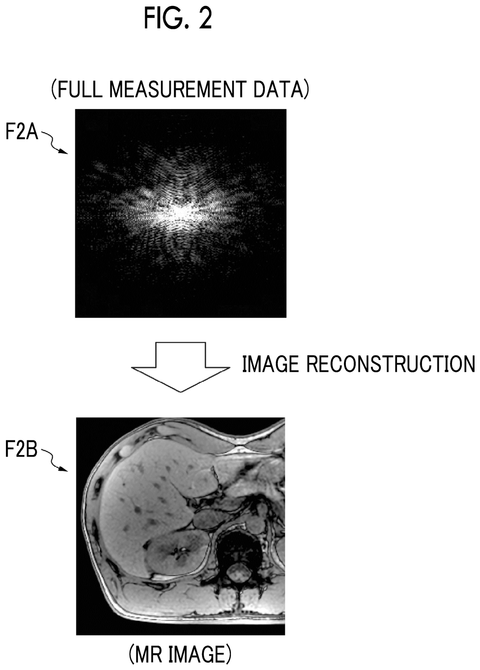

FIG. 2 is a diagram illustrating examples of full measurement data of the k-space and the MR image reconstructed from the full measurement data. The "full measurement data" refers to complete k-space data that is data collected in an entire region of a matrix of the k-space set by the imaging parameters as a measurement region. The matrix of the k-space is defined by the FOV, the number of pixels in the frequency encoding direction, and the number of pixels in the phase encoding direction.

In a case in which a matrix size of an imaging field of view (FOV) is set to 256 × 256, the data in the k-space is data (also referred to as "raw data") sampled at equal intervals (data pitch Δk) at 256 points × 256 points of the k-space. In addition, the upper and lower limits of the acquisition of the data in the k-space are determined in accordance with the spatial resolution of the MR image.

The data near the origin of the k-space (portion in which the values of kx and ky are small) has a low spatial frequency, and a component representing a rough structure of the image is present, and the data in a peripheral portion of the k-space (portion in which the value of kx or ky is large) has a high spatial frequency, and a component representing a fine structure of the image is present.

Full measurement data F2A is complex data, and includes real part k-space data and imaginary part k-space data. The full measurement data F2A illustrated in the upper part of FIG. 2 is displayed as a complex amplitude image. An image F2B reconstructed by performing an inverse Fourier transform on the full measurement data F2A is a complex image. The image F2B illustrated in the lower part of FIG. 2 is displayed as an absolute value image obtained by performing absolute value image generation on the complex image.

### Collection of Data of k-Space

The MRI apparatus 10 controls the sampling timing of the RF pulse, the gradient magnetic fields Gx, Gy, and Gz, and the echo signal generated from the RF coil 108 in accordance with the pulse sequence selected depending on the examination part and the imaging purpose, and collects the data that fills the k-space.

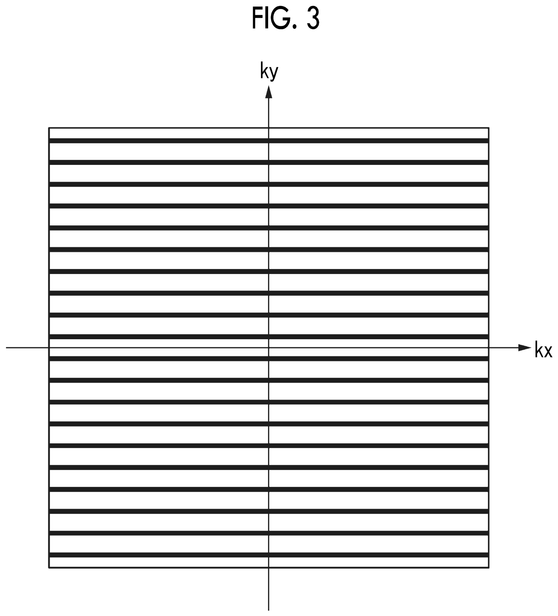

FIG. 3 is a diagram illustrating examples of each point (kx, ky) of the data arranged in the k-space and the k-trajectory. Here, as an example, a case will be described in which the kx axis is the frequency encoding axis and the ky axis is the phase encoding axis. For example, in a case of the pulse sequence of the spin echo method, the gradient magnetic field Gx is generated in synchronization with the period during which the echo signal is generated, and the echo signal is sampled during the period to collect data for one line in the kx direction of the k-space. The collection of the data for one line is performed for each repetition time TR. That is, the data in the kx direction of the k-space is collected by one echo. The kx direction is also referred to as a "readout direction". The data in the ky direction is collected by varying the intensity of the gradient magnetic field Gy for each TR in the collection of the data in the kx direction. For example, the full measurement data in a case in which the matrix size of the k-space is 256 × 256 is data of 256 points of sampling in the frequency encoding direction × the number of steps 256 in the phase encoding direction. Therefore, it takes a time of "TR × the number of steps of phase encoding" to collect the full measurement data for filling the entire region of the k-space having the designated matrix size. In the pulse sequence of the spin echo method or the like, it takes several minutes to collect the full measurement data that fills the k-space as the imaging time.

### Example of Reduction in Imaging Time by Partial Sampling of k-Space

In the related art, a half-Fourier method is known as a method of reducing the imaging time. In the half-Fourier method, data of an asymmetrical measurement region that is a partial region in the k-space is collected instead of collecting the full measurement data. For example, a method called half-scan that reduces the number of steps in the phase encoding direction and a method called half-echo that reduces the number of sampling points in the frequency encoding direction are known.

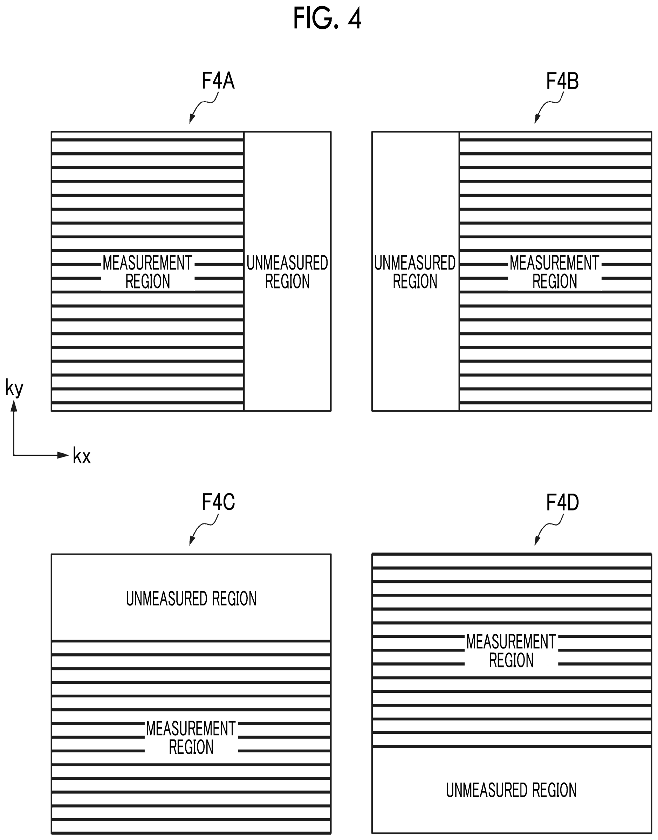

FIG. 4 is a diagram illustrating an example of a data filling method using the asymmetric k-space sampling. As a pattern in which the unmeasured region other than the measurement region is set in one of four directions, that is, up, down, left, and right, on the two-dimensional plane of the k-space, there are four possible patterns as illustrated in FIG. 4.

In a k-space F4A illustrated in the upper left of FIG. 4, the unmeasured region is present in the right direction (positive kx direction) of the k-space, and the data is collected in a region other than the unmeasured region as the measurement region. As a result, partial k-space data in which the measurement data fills the asymmetrical measurement region in the k-space F4A is obtained.

In a k-space F4B illustrated in the upper right of FIG. 4, the unmeasured region is present in the left direction (negative kx direction) of the k-space. In addition, in a k-space F4C illustrated in the lower left of FIG. 4, the unmeasured region is present in the up direction (positive ky direction) of the k-space, and in a k-space F4D illustrated in the lower right of FIG. 4, the unmeasured region is present in the down direction (negative ky direction) of the k-space.

As in the k-spaces F4A and F4B illustrated in the upper part of FIG. 4, in a case in which the k-space is filled with the measurement data collected by the half-echo method in which the number of sampling points in the frequency encoding direction is small, the collection time of the data for one line in the frequency encoding direction can be reduced, and particularly in a case in which the pulse sequence is EPI, the data of the k-space required for reconstructing one MR image can be collected in a shorter time.

In addition, as in the k-spaces F4C and F4D illustrated in the lower part of FIG. 4, in a case in which the k-space is filled with the measurement data collected by the half-scan method in which the number of steps in the phase encoding direction is small, the number of phase encodings is reduced, and the imaging time can be reduced regardless of the type of the pulse sequence.

In FIG. 4, the example has been described in which the unmeasured region is set in any one direction among the four directions of up, down, left, and right of the k-space, but the k-space to which the half-Fourier method can be applied is not limited to the four patterns of the k-space illustrated in FIG. 4, and a k-space in which both the half-scan and the half-echo are used and two adjacent regions among the asymmetrical regions in the four directions of up, down, left, and right of the k-space are set as the unmeasured regions may be used. From the symmetry (Hermitian symmetry) of the k-space information, the measurement region of the k-space may be a region exceeding one quadrant of the first quadrant to the fourth quadrant in which the two-dimensional plane of the k-space is divided into four quadrants with the origin of the kx axis and the ky axis as the center.

In this specification, the measurement data of the k-space including the unmeasured region is referred to as "partial measurement data".

### Method of Improving MR Image: CNN Estimation Method

The half-Fourier method has a disadvantage that the image quality of the reconstruction image is significantly degraded (deteriorates) as the unmeasured region becomes large. On the other hand, there is also a method of, for the k-space including the asymmetrical unmeasured region illustrated in FIG. 4, generating the reconstructed image by performing an inverse discrete Fourier transform on the k-space data complemented by filling the unmeasured region with zero data without applying Hermitian-symmetry-based complement. However, the reconstruction image reconstructed by such a simple zero-filling complement has degraded image quality due to zero data filling the unmeasured region.

As one of the techniques for estimating the asymmetrical unmeasured region in the k-space for improving the image quality of the reconstruction image based on the partial k-space data obtained from the sampling region set asymmetrically on the k-space, US2022/0198725A proposes a method of improving the image quality of the MR image by using a trained neural network model trained through machine learning. The neural network model is, for example, a multi-layer convolutional neural network (CNN) model.

### CNN Estimation Method

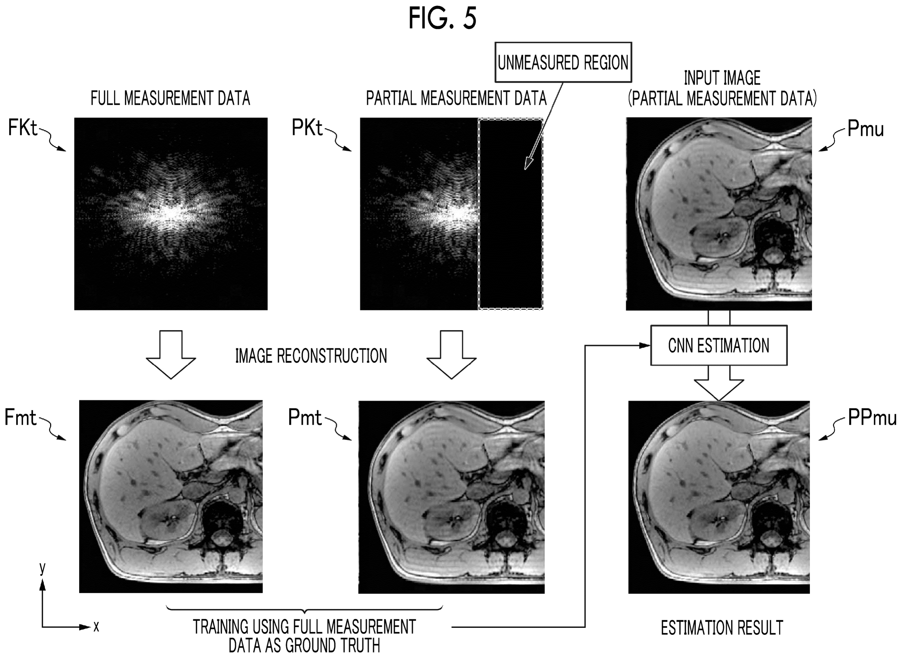

FIG. 5 is a conceptual diagram illustrating the method of improving the degradation of image quality of the MR image using the CNN. In this specification, a method of estimating the data of the unmeasured region using the trained CNN through machine learning to improve the image quality of the reconstruction image is referred to as a "CNN estimation method".

In the CNN estimation method, first, as a preliminary preparation, the trained CNN is generated by machine learning. In this training phase, machine learning is performed using, as the training data, a pair of a full measurement image Fmt that is the reconstruction image reconstructed from full measurement data Fkt and a partial measurement image Pmt that is the reconstruction image reconstructed from partial measurement data PKt corresponding to the full measurement image Fmt, and the full measurement image Fmt being ground-truth data, so that the trained CNN trained to estimate the full measurement image Fmt from the partial measurement image Pmt is generated. The subscript "t" in the symbols such as Fkt and PKt is an index representing a "pair" of data in the training dataset.

The partial measurement data PKt can be generated by replacing the data of a partial region of the full measurement data Fkt with zero data. That is, by regarding the partial region of the k-space matrix of the full measurement data Fkt as the unmeasured region and replacing the data of the partial region with zero data, the partial measurement data PKt equivalent to the measurement data obtained by the asymmetric sampling can be generated. A direction in which the region regarded as the unmeasured region in the k-space is set and a proportion of the unmeasured region with respect to the entire region of the matrix size of the k-space can be arbitrarily set, and the partial measurement data obtained by the asymmetric sampling under various conditions can be pseudo-generated.

The number of image pairs in the training dataset used for the machine learning of the CNN is preferably about 40,000. In the training dataset in a case in which one CNN is trained through machine learning, it is desirable that the directions of the unmeasured region of the partial measurement data Pkt corresponding to the partial measurement image Pmt in the k-space are the same direction, and the proportions of the unmeasured region in the k-space are also the same. In this specification, the direction of the unmeasured region in the k-space is referred to as an "unmeasured direction", and the proportion of the unmeasured region with respect to the entire region of the matrix size of the k-space is referred to as an "unmeasured proportion".

For example, since the unmeasured direction of the partial measurement data PKt illustrated in FIG. 5 is the right in FIG. 5, the unmeasured direction of the k-space data corresponding to each of a plurality of partial measurement images Pmt included in the training dataset is the right direction. In addition, in a case in which the unmeasured proportion of the partial measurement data PKt is 40%, the unmeasured proportion of the k-space corresponding to each of the plurality of partial measurement images Pmt included in the training dataset is also 40%.

As a result, it is possible to generate the trained CNN having high estimation accuracy for the input of the partial measurement image in which the unmeasured direction is the right direction and the unmeasured proportion is 40%.

Similarly, a plurality of types of trained CNNs can be generated by using the training dataset in which the conditions of the unmeasured direction and the unmeasured proportion are different.

The right column of FIG. 5 represents an inference phase in which the full measurement image is estimated based on a partial measurement image Pmu using the trained CNN.

The partial measurement image Pmu that is the input image to the trained CNN is a reconstruction image reconstructed by performing an inverse Fourier transform on zero-filling partial measurement data complemented by filling the unmeasured region of the partial measurement data collected from the asymmetrical measurement region in the k-space with zero data. The "inverse Fourier transform" in the processing of the computer is an "inverse discrete Fourier transform", and an inverse fast Fourier transform (IFFT) is applied in the present embodiment. The image quality of this input image is degraded as compared with the reconstruction image reconstructed from the full measurement data.

The trained CNN to which the partial measurement image Pmu is input estimates the full measurement image from the partial measurement image Pmu and outputs an estimation image PPmu as the estimation result. The estimation image PPmu is an image in which the degradation of image quality of the input image is reduced (improved). In a case in which the function of the trained CNN is reconsidered as an action on the data of the k-space, it is understood that the trained CNN has a function of estimating the data of the unmeasured region.

### Example of CNN

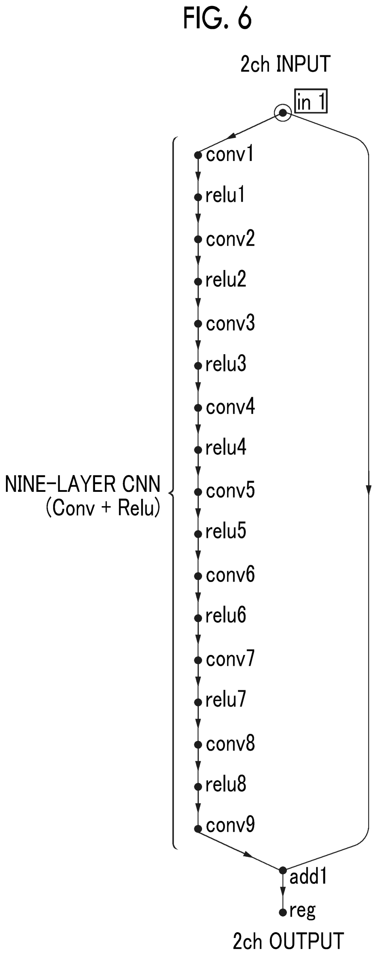

FIG. 6 is a diagram illustrating an example of a network structure of the CNN applied as the trained model. The CNN illustrated in FIG. 6 is a neural network that receives the input of the complex image and outputs the complex image, and is a multi-layer neural network model having two-channel input and two-channel output, in which each of an input channel and an output channel includes a real part and an imaginary part.

The CNN illustrated in FIG. 6 has a network structure of residual learning in which input data is output by being added to the output of a multi-layer CNN in which a plurality of stages of convolutional layers (Conv) and activation layers (Relu) are sequentially connected. Here, the notation "Relu" represents a rectified linear unit applied to the activation layer.

In the neural network model of FIG. 6, the degradation of image quality of the complex image is estimated for the two-channel complex image input to an input layer (in1) through nine convolutional layers (Conv1 to 9) and eight activation layers (Relu1 to 8), and the two-channel correction information for correcting the degradation of image quality is output to an addition layer (add1). The input layer (in1) is connected to another input of the addition layer (add1), and the two-channel complex image input to the input layer (in1) is added thereto. The addition layer (add1) adds the two-channel complex image input to the input layer (in1) and the two-channel correction information output from the convolutional layer (Conv9), and outputs the two-channel image (complex image) (degradation of image quality is reduced) as an addition result as the output image via a reg layer. The reg layer may be understood as an output layer that outputs an addition result of the addition layer (add1).

In FIG. 6, the neural network model of the residual learning including the nine-layer CNN is illustrated, but the number of convolutional layers, the number of rectified linear units, and the structure of the network are not particularly limited, and are not limited to the embodiment illustrated in FIG. 6. For example, the network structure may not have the addition layer or may have a pooling layer, and a network such as a U-Net may be used. The CNN applied to the MRI apparatus 10 can have various layer structures. Further, the trained model applied to the MRI apparatus 10 is not limited to the CNN, and may be another machine learning model, and any model may be used as long as the model is trained using a machine learning dataset. The "neural network", the "trained model", and the like are, in substance, programs.

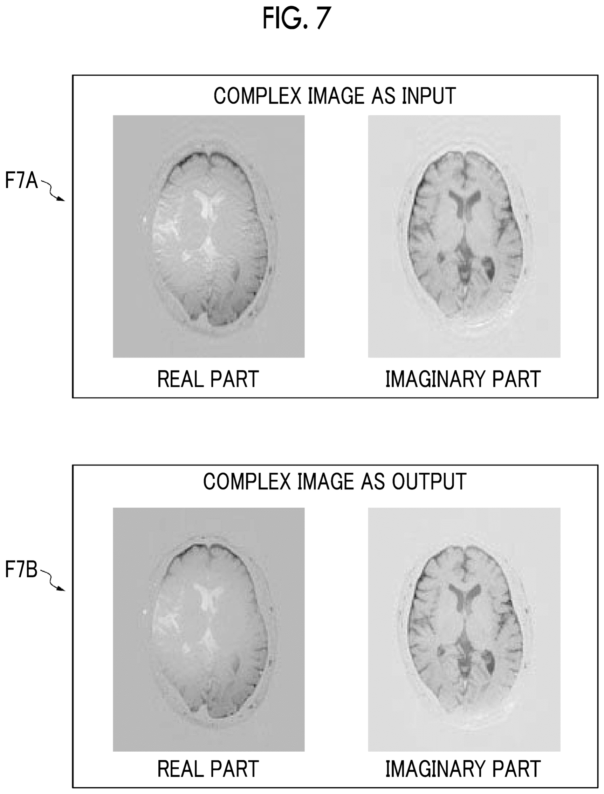

FIG. 7 is a diagram illustrating an example of the input image and the output image of the CNN illustrated in FIG. 6. As illustrated in the upper part of FIG. 7, a two-channel complex image F7A of a real part image and an imaginary part image is input to the input layer (in1) of the CNN illustrated in FIG. 6.

The measurement data measured by the MRI apparatus is complex data, and the real part data and the imaginary part data are arranged in the real part k-space and the imaginary part k-space, respectively. The complex image F7A illustrated in FIG. 7 is a real part image obtained by performing an inverse Fourier transform on the data of the real part k-space and an imaginary part image obtained by performing an inverse Fourier transform on the data of the imaginary part k-space. The complex image F7A is an example of an image reconstructed from k-space data obtained by zero-filling complement of the partial measurement data with the unmeasured proportion of 40%.

The CNN illustrated in FIG. 6 receives the input of the complex image F7A and outputs a complex image F7B illustrated in the lower part of FIG. 7.

### Method of Generating Training Image Set

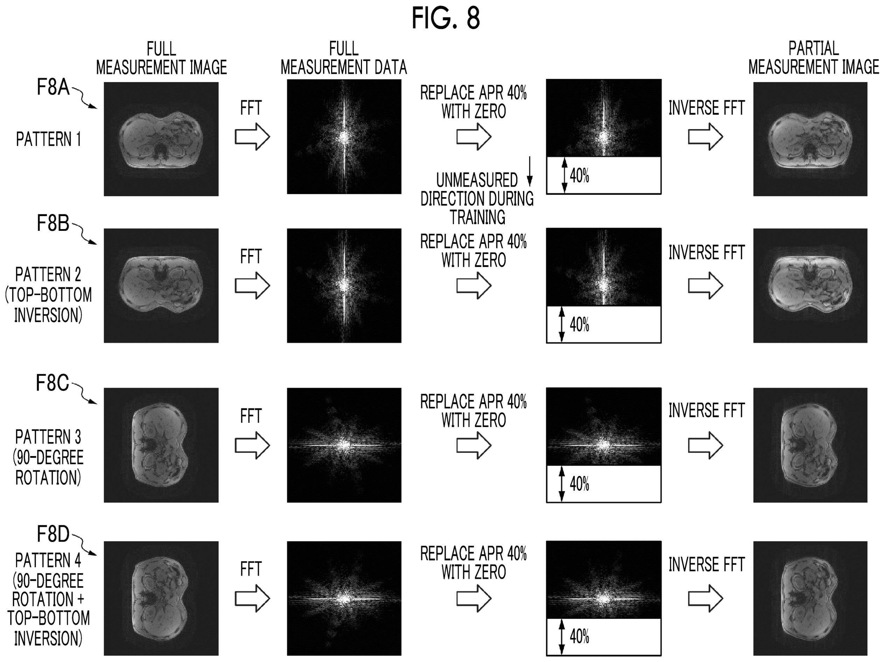

FIG. 8 is a diagram illustrating an example of a method of generating the training image set for training the CNN. The partial measurement image used for the machine learning can be generated from the full measurement image. Each of the full measurement image and the partial measurement image is a complex image, but in FIG. 8, for convenience of illustration, an absolute value image is displayed.

FIG. 8 illustrates an outline of a method of generating the training image sets corresponding to four patterns 1 to 4 in which the unmeasured directions are different from one full measurement image.

An image generation process F8A illustrated in the first row, which is the uppermost part of FIG. 8, is a method of generating the partial measurement image corresponding to the reconstruction image of the partial measurement data in a case (pattern 1) in which the unmeasured direction is present in the negative direction of the ky axis in the k-space (kx, ky).

The full measurement image in the leftmost part of the first row is the full measurement image reconstructed from the full measurement data in the k-space, and is used as the ground-truth data as it is.

Meanwhile, the partial measurement image that is the training image paired with the ground-truth data is generated as follows.

The unmeasured region that is asymmetrically set in advance is filled with zero data for the full measurement data in the k-space obtained by performing a fast Fourier transform on the full measurement image. That is, the measurement data corresponding to the preset unmeasured region of the full measurement data in the k-space is replaced with the zero data. In a case of the pattern 1, the unmeasured direction is the down direction on FIG. 8, and the unmeasured proportion is 40%. The partial measurement image reconstructed by performing an inverse fast Fourier transform on the partial k-space data generated in this way is used as the training image.

An image generation process F8B illustrated in the second row of FIG. 8 is a method of generating the partial measurement image corresponding to the reconstruction image of the partial measurement data in a case (pattern 2) in which the unmeasured direction is present in the positive direction of the ky axis in the k-space (kx, ky).

The full measurement image illustrated in the leftmost part of the second row is a top-bottom inverted image in which the top and bottom of the full measurement image illustrated in the first row are inverted, and this top-bottom inverted image is used as the ground-truth data.

Then, the measurement data of the unmeasured region that is asymmetrically set in advance is replaced with zero data for the full measurement data in the k-space obtained by performing a fast Fourier transform on the top-bottom inverted image. In a case of the pattern 2, the unmeasured direction of the top-bottom inverted k-space is the down direction on FIG. 8, and the unmeasured proportion is 40%. The partial measurement image reconstructed by performing an inverse fast Fourier transform on the partial k-space data generated in this way is used as the training image.

An image generation process F8C illustrated in the third row of FIG. 8 is a method of generating the partial measurement image corresponding to the reconstruction image of the partial measurement data in a case (pattern 3) in which the unmeasured direction is present in the positive direction of the kx axis in the k-space (kx, ky).

The full measurement image illustrated in the leftmost part of the third row is a 90-degree rotated image in which the full measurement image illustrated in the first row is rotated by 90 degrees clockwise, and this 90-degree rotated image is used as the ground-truth data.

Then, the measurement data of the unmeasured region that is asymmetrically set in advance is replaced with zero data for the full measurement data in the k-space obtained by performing a fast Fourier transform on the 90-degree rotated image. In a case of the pattern 3, the unmeasured direction of the k-space rotated by 90 degrees is the down direction on FIG. 8, and the unmeasured proportion with respect to the entire region of the k-space is 40%. The partial measurement image reconstructed by performing an inverse fast Fourier transform on the partial k-space data generated in this way is used as the training image.

An image generation process F8D illustrated in the fourth row, which is the lowermost part of FIG. 8, is a method of generating the partial measurement image corresponding to the reconstruction image of the partial measurement data in a case (pattern 4) in which the unmeasured direction is present in the negative direction of the kx axis in the k-space (kx, ky).

The full measurement image illustrated in the leftmost part of the fourth row is an image obtained by further inverting the top and bottom of the 90-degree rotated image illustrated in the third row (an image in which the full measurement image of the first row is rotated by 90 degrees and then top-bottom inverted), and this image is the ground-truth data.

Then, the measurement data of the unmeasured region that is asymmetrically set in advance is replaced with zero data for the full measurement data in the k-space obtained by performing a fast Fourier transform on the full measurement image illustrated in the fourth row. In a case of the pattern 4, the unmeasured direction of the k-space rotated by 90 degrees and top-bottom inverted is the down direction on FIG. 8, and the unmeasured proportion is 40%. The partial measurement image reconstructed by performing an inverse fast Fourier transform on the partial k-space data generated in this way is used as the training image.

With the method of generating the training image set, the training image sets corresponding to the patterns 1 to 4 can be efficiently generated from one full measurement image.

In addition, the training image sets illustrated in the patterns 1 to 4 have the proportion of the unmeasured region of 40% with respect to the entire region of the k-space, but the training image set can be generated in the same manner for a proportion other than the proportion of the unmeasured region of 40%.

Further, in the example illustrated in FIG. 8, the full measurement data of the k-space corresponding to the full measurement image is acquired by performing a Fourier transform on the full measurement image corresponding to the patterns 1 to 4, but in a case in which the full measurement data in the k-space acquired during the imaging is stored, the stored full measurement data may be top-bottom inverted and/or rotated by 90 degrees to acquire the full measurement data in the k-space corresponding to the patterns 1 to 4.

### Processor

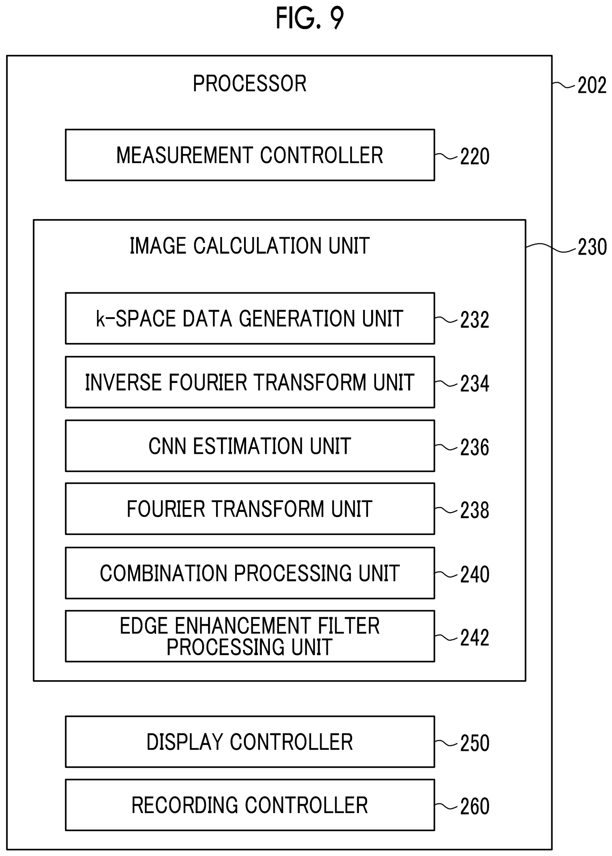

FIG. 9 is a functional block diagram of the processor 202 of the control device 200 illustrated in FIG. 1. As illustrated in FIG. 9, the processor 202 executes various programs and the trained model stored in the memory 204 to function as a measurement controller 220, an image calculation unit 230, a display controller 250, and a recording controller 260.

The trained model stored in the memory 204 may be trained to receive an input of an input reconstruction image (an example of an "input image") in which the data of the k-space including the data of the measurement region is reconstructed, and output an estimated reconstruction image (an example of an "estimation image") in which the data of the unmeasured region other than the measurement region is estimated. The trained model may be trained through machine learning to receive an input of the input reconstruction image in which the data of the k-space consisting of the measurement region filled with the input measurement region data and the unmeasured region filled with zero data is reconstructed, and estimate and output the estimated reconstruction image of the real space that is reconstructed from the data of the k-space consisting of the measurement region filled with the estimated measurement region data and the unmeasured region filled with the estimated unmeasured region data. The trained model may be a trained CNN trained using the training image sets corresponding to the patterns 1 to 4 generated by the method of generating the training image sets illustrated in FIG. 8.

Further, the trained model may be trained through machine learning to receive an input of the input reconstruction image in which the data of the k-space consisting of the measurement region filled with the input measurement region data and the unmeasured region filled with zero data is reconstructed, and estimate and output an estimated residual image (an example of an "estimation image") indicating a residual between the input reconstruction image and the estimated reconstruction image of the real space that is reconstructed from the data of the k-space consisting of the measurement region filled with the estimated measurement region data and the unmeasured region filled with the estimated unmeasured region data.

The measurement controller 220 transmits a predetermined pulse sequence, the imaging conditions (imaging parameters) designated by the operator, and the like to the sequencer 118 (see FIG. 1) of the measurement unit 100, and controls the measurement unit 100 via the sequencer 118. In the present example, the sequence for performing the half-scan of reducing the number of steps in the phase encoding direction and/or the half-echo of reducing the number of sampling points in the frequency encoding direction is selected. Further, the proportion of the asymmetrical unmeasured region of the k-space in a case of performing the half-scan or the half-echo is set to any of 1% to 45% by the operator, and the direction of the unmeasured region is also set by the operator.

The measurement controller 220 transmits a command to the sequencer 118 in accordance with the set conditions, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the amplification, the detection, and the A/D conversion of the echo signal received by the receive coil 110, and transmits the digital data of the real part and the imaginary part to the control device 200 via the input/output interface 206.

The image calculation unit 230 includes a k-space data generation unit 232, an inverse Fourier transform unit 234, a CNN estimation unit 236, a Fourier transform unit 238, a combination processing unit 240, an edge enhancement filter processing unit 242, and the like.

The k-space data generation unit 232 arranges the k-space data that is the digital data of the real part and the imaginary part and that is sequentially collected from the echo signal along the k-trajectory in the k-space. In a case in which the size of the FOV is set to 256 pixels × 256 pixels, the entire region of the k-space also has a size of 256 × 256, but the data of the asymmetrical unmeasured region of the entire region of the k-space by the half-scan and/or the half-echo is not collected, and the k-space data generation unit 232 acquires the partial measurement data of the measurement region excluding the unmeasured region arbitrarily set for the k-space and arranges the partial measurement data in the k-space, and fills the unmeasured region with zero data to generate the data of the k-space.

It goes without saying that, in a case in which the entire region of the k-space before the partial measurement data is arranged is filled with zero data, it is not necessary to perform the processing of filling the unmeasured region with zero data.

The inverse Fourier transform unit 234 is a unit that performs an inverse Fourier transform (inverse fast Fourier transform (FFT)) on the data of the k-space generated by the k-space data generation unit 232, and converts the data into the reconstruction image (MR image) of the real space.

The CNN estimation unit 236 is a unit that uses the CNN stored in the memory 204, estimates and corrects the degradation of image quality due to the noise or the like estimated from the input image (complex image) of the CNN as described with reference to FIGS. 6 and 7, and outputs the image (complex image) in which the degradation of image quality is reduced for the input complex image.

The Fourier transform unit 238 is a unit that performs a Fourier transform (FFT) on the complex image in which the degradation of image quality is reduced to generate the data of the k-space, and functions as a portion of the k-space data generation unit 232.

The combination processing unit 240 is a unit that combines the data of the k-space, and functions as a portion of the k-space data generation unit 232.

The edge enhancement filter processing unit 242 is a unit that performs edge enhancement processing on the reconstruction image of the real space with a predetermined intensity using the edge enhancement filter. The edge enhancement filter is, for example, unsharp mask processing. The edge enhancement filter processing unit 242 can adjust the strength of the edge enhancement by continuously or discretely adjusting the strength of the unsharp mask processing, for example.

The display controller 250 displays the MR image calculated by the image calculation unit 230 and necessary accessory information (for example, information on the imaging conditions and the subject 102) on the display 208 (FIG. 1), and displays the MR image and the like recorded in the memory 204 on the display 208.

The recording controller 260 records the MR image with the accessory information in, for example, a medical image format of digital imaging and communications in medicine (DICOM) in the memory 204. The MR image in this case is recorded as a sum-of-squares image of the complex image.

### Degradation in Resolution

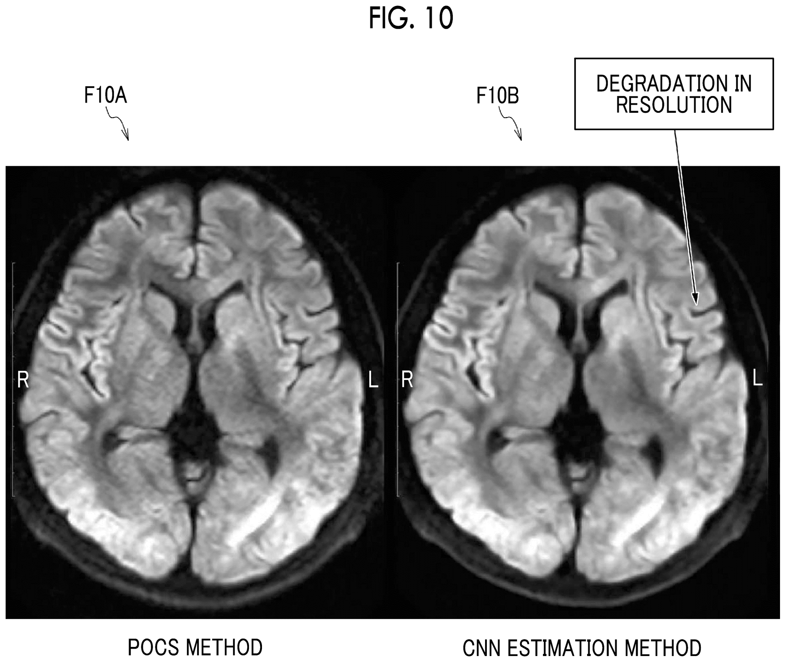

FIG. 10 is a diagram illustrating the degradation in resolution of the MR image by the CNN estimation method. F10A of FIG. 10 illustrates the MR image in a case in which the data of the unmeasured region is estimated by using a projection onto convex sets (POCS) method (see E.M Haacke, E.D Lindskog, W Lin, "A fast, iterative, partial-fourier technique capable of local phase recovery", Journal of Magnetic Resonance, Volume 92, Issue 1,1991 and Partial k-space Reconstruction, the internet <URL: https://users.fmrib.ox.ac.uk/~karla/reading_group/lecture_notes/Recon_Pauly_read.pdf>). In addition, F10B of FIG. 10 illustrates the MR image in a case in which the data of the unmeasured region is estimated by the CNN estimation method. F10A and F10B are head diffusion-weighted images in which the unmeasured proportion is 40%. As illustrated in FIG. 10, the MR image using the CNN estimation method has degraded resolution as compared with the MR image using the POCS method.

### First Embodiment

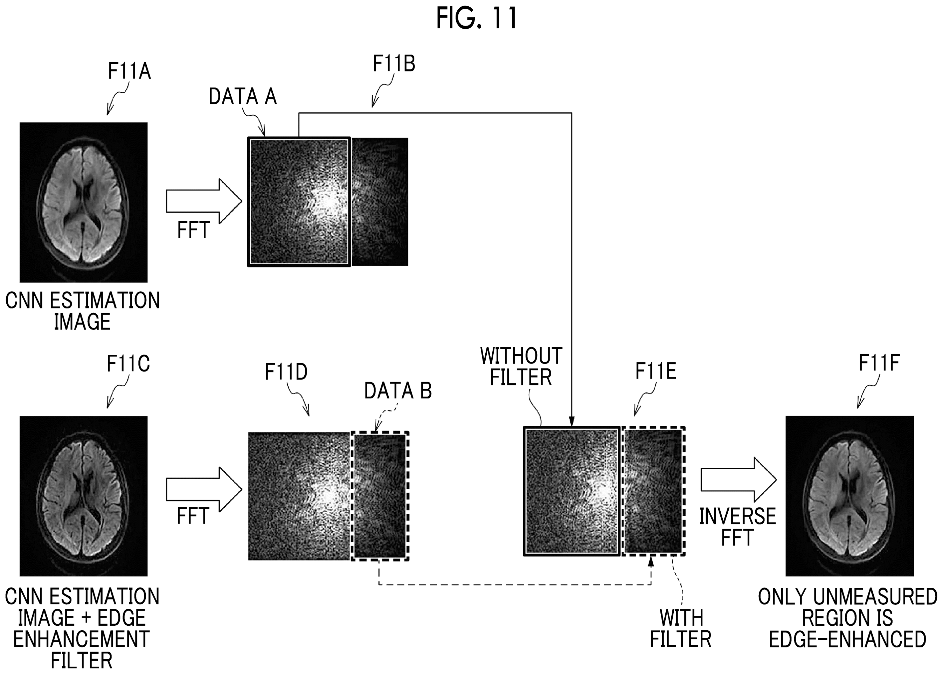

The generation method of the MR image according to the first embodiment is a method executed by the processor 202 that converts the data acquired by imaging the subject into an image, and is a method for obtaining the MR image in which the resolution of the data of the unmeasured region is improved while the increase in noise of the data of the measurement region of the MR image estimated by the CNN estimation method is suppressed. FIG. 11 is a diagram illustrating the image processing method according to the first embodiment.

F11A of FIG. 11 illustrates an example of the CNN estimation image that is the reconstruction image in which the data of the unmeasured region is estimated by the CNN estimation method from the partial measurement data of the asymmetrical measurement region on the k-space. In addition, F11B of FIG. 11 illustrates the data of the k-space that is a result of performing a Fourier transform on the CNN estimation image of F11A.

F11C of FIG. 11 illustrates an edge enhancement estimation image that is a result of performing edge enhancement filter processing on the CNN estimation image of F11A. In addition, F11D of FIG. 11 illustrates the data of the k-space that is a result of performing a Fourier transform on the edge enhancement estimation image of F11C.

F11E of FIG. 11 illustrates the data of the k-space in which data A that is the data of the measurement region in the data of the k-space of F11B and data B that is the data of the unmeasured region in the data of the k-space of F11D are combined. That is, the data of the k-space of F11E is data in which the data A of the measurement region to which the edge enhancement filter is not applied and the data B of the unmeasured region to which the edge enhancement filter is applied are combined. The data of the k-space of F11E is synonymous with the data of the k-space of F11B in which the data of the unmeasured region is replaced with the data B, and the data of the k-space of F11D in which the data of the measurement region is replaced with the data A.

F11F of FIG. 11 illustrates the MR image that is the output image in which the data of the k-space of F11E is subjected to an inverse Fourier transform. In the MR image of F11F, only the data of the unmeasured region is enhanced. Accordingly, in the MR image of F11F, the increase in noise of the data of the measurement region is suppressed, and the resolution of the data of the unmeasured region is improved.

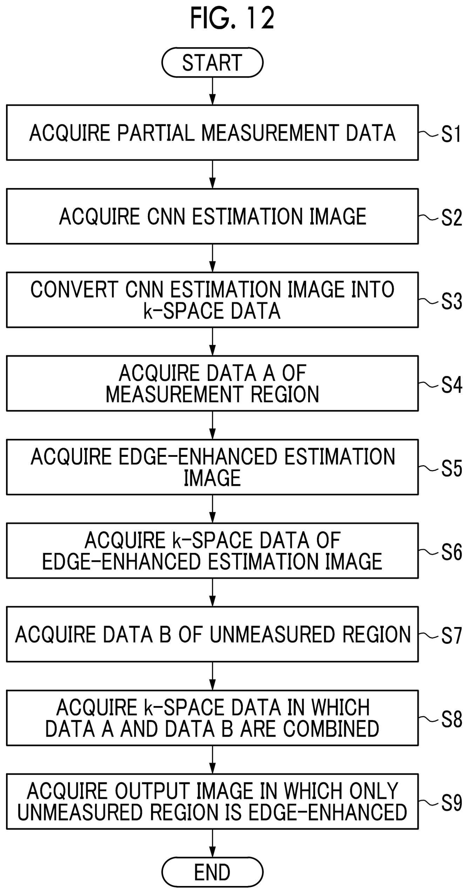

FIG. 12 is a flowchart illustrating steps of the generation method of the MR image (an example of an "image processing method") according to the first embodiment. The generation method of the MR image is implemented by the processor 202 of the control device 200 (an example of an "image processing apparatus") executing a program for generating the MR image stored in the memory 204.

In step S1, the processor 202 acquires the partial measurement data. The partial measurement data is data obtained by imaging the subject 102 via the measurement unit 100 and measured in the asymmetrical measurement region on the k-space. The direction of the unmeasured region of the k-space and the proportion of the unmeasured region to the entire region of the k-space are determined as appropriate. Here, the measurement controller 220 causes the measurement unit 100 to execute the pulse sequence by the half-scan and/or the half-echo, and acquires the digital data of the real part and the imaginary part from the receiver 116 as the partial measurement data.

In step S2, the processor 202 acquires the CNN estimation image from the partial measurement data acquired in step S1. The processor 202 acquires the CNN estimation image using the CNN stored in the memory 204. The CNN is, for example, a CNN that receives an input of the input reconstruction image, and estimates and outputs the estimated reconstruction image. Here, the k-space data generation unit 232 generates the data of the k-space by arranging the partial measurement data in the measurement region of the k-space and filling the unmeasured region with zero data. The inverse Fourier transform unit 234 performs an inverse Fourier transform on the data of the k-space to convert the data into the MR image (an example of a "first reconstruction image") of the real space. The CNN estimation unit 236 inputs the MR image converted by the inverse Fourier transform unit 234 to the CNN, and acquires the CNN estimation image (an example of a "second reconstruction image") output from the CNN.

The CNN may be a CNN that receives an input of the input reconstruction image, and estimates and outputs the estimated residual image. In this case, the CNN estimation unit 236 may acquire the CNN estimation image (an example of a "second reconstruction image") from the MR image input to the CNN and the estimated residual image output from the CNN.

In step S3, the processor 202 converts the CNN estimation image acquired in step S2 into the data of the k-space. Here, the Fourier transform unit 238 performs a Fourier transform on the CNN estimation image to generate the data of the k-space.

In step S4, the processor 202 acquires the data A (an example of "first measurement region data") of the measurement region of the k-space. Here, the combination processing unit 240 acquires, as the data A, the entire data of the measurement region in the data of the k-space converted in step S3.

In step S5, the processor 202 acquires the edge enhancement estimation image (an example of a "third reconstruction image"). Here, the edge enhancement filter processing unit 242 performs the edge enhancement filter processing on the CNN estimation image acquired in step S2 to generate the edge enhancement estimation image.

In step S6, the processor 202 acquires the data of the k-space of the edge enhancement estimation image acquired in step S5. Here, the Fourier transform unit 238 performs a Fourier transform on the edge enhancement estimation image to generate the data of the k-space.

In step S7, the processor 202 acquires the data of the unmeasured region (an example of "first unmeasured region data") in the data of the k-space acquired in step S6. Here, the combination processing unit 240 acquires, as the data B, the entire data of the unmeasured region in the data of the k-space converted in step S6.

In step S8, the processor 202 acquires the k-space data obtained by combining the data A acquired in step S4 and the data B acquired in step S7. Here, the combination processing unit 240 generates the data of the k-space by filling the measurement region of the k-space with the data A and filling the unmeasured region of the k-space with the data B.

Finally, in step S9, the processor 202 acquires the output image (an example of a "fourth reconstruction image") in which only the data of the unmeasured region is enhanced. Here, the inverse Fourier transform unit 234 performs an inverse Fourier transform on the data of the k-space acquired in step S8 to reconstruct the MR image that is the output image. In the MR image acquired in this way, the noise of the data of the measurement region is suppressed, the edge of the data of the unmeasured region is enhanced, and the resolution is improved.

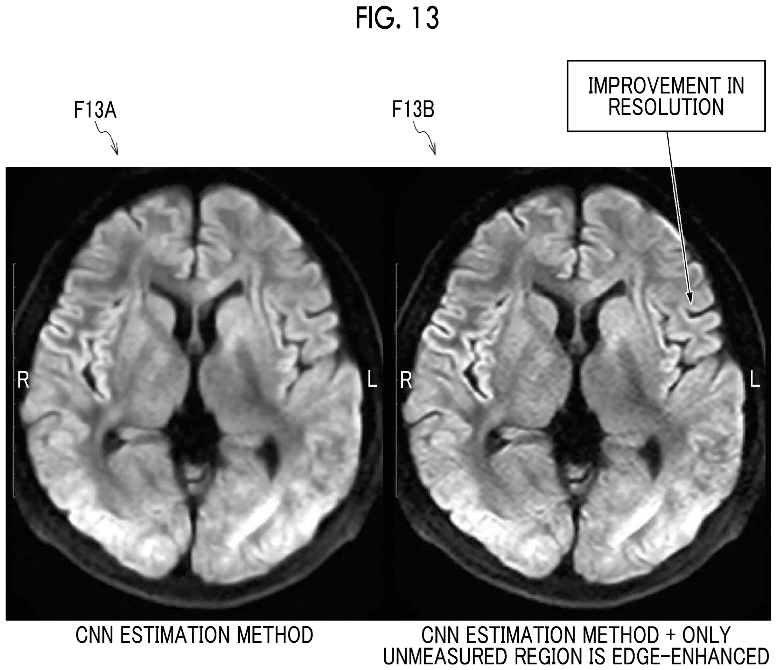

FIG. 13 is a diagram illustrating the improvement in resolution. F13A of FIG. 13 illustrates the MR image in a case in which the data of the unmeasured region is estimated by the CNN estimation method, and is the head diffusion-weighted image in which the unmeasured proportion is 40%. In addition, F13B of FIG. 13 illustrates the MR image generated by the generation method of the MR image according to the first embodiment, and is the MR image in which only the data of the unmeasured region of the MR image of F13A is subjected to the edge enhancement processing. As illustrated in FIG. 13, the resolution of the MR image of F13B is improved.

The edge enhancement filter processing unit 242 may acquire the strength of the edge enhancement in the edge enhancement filter processing based on the average value of the absolute values of the data of the measurement region that is symmetric to the unmeasured region of the k-space in the data A of the measurement region of the k-space and the average value of the absolute values of the data B of the unmeasured region. For example, the edge enhancement filter processing unit 242 may determine the strength of the edge enhancement to the strength at which the average value of the absolute values of the data of the measurement region that is symmetric to the unmeasured region and the average value of the absolute values of the data B are at the same level. Here, "approximately equal" is preferably within ±5%, more preferably within ±3%, and still more preferably within ±1%.

In addition, the edge enhancement filter processing unit 242 may receive the input of the strength from the operator and perform the edge enhancement filter processing with the received strength. The processor 202 may display the output image and a slider bar for adjusting the strength of the edge enhancement filter processing on the display 208. In this case, the strength is determined in accordance with the position of the slider of the slider bar. As a result, the operator can change the position of the slider of the slider bar while visually recognizing the output image to adjust the strength of the edge enhancement filter processing to appropriate strength.

### Second Embodiment

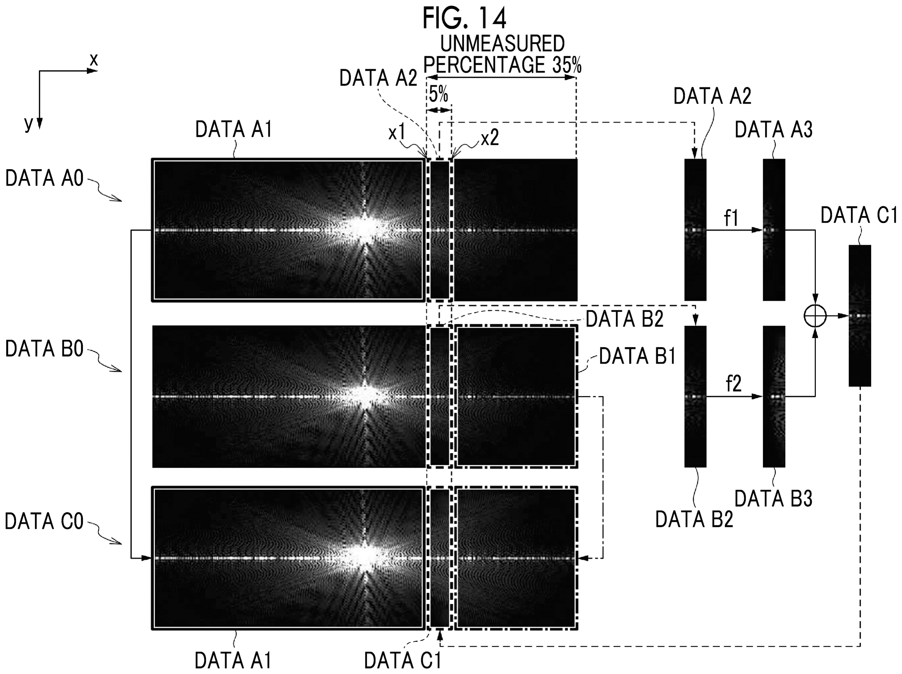

The generation method of the MR image according to the second embodiment obtains the MR image in which the data of the measurement region to which the edge enhancement is not applied and the data of the unmeasured region to which the edge enhancement is applied are smoothly connected in the MR image estimated by the CNN estimation method. FIG. 14 is a diagram illustrating the image processing method according to the second embodiment.

Data A0 illustrated in FIG. 14 is data of the k-space that is a result of performing a Fourier transform on the CNN estimation image in which the data of the unmeasured region is estimated by the CNN estimation method from the partial measurement data of the asymmetrical measurement region on the k-space. In the k-space having the data A0, the unmeasured region is present in the right direction (x direction of FIG. 14) of the k-space, and the unmeasured proportion is 35%. The data A0 includes data A1 and data A2. The data A1 is data of the measurement region in the data A0. The data A2 is data of an adjacent region that is a region from a position x1 of a boundary between the measurement region and the unmeasured region to a position x2 that is 5% of the data size in the x direction away from the position x1 in the data of the unmeasured region of the data A0. In FIG. 14, the x direction means the kx axis direction.

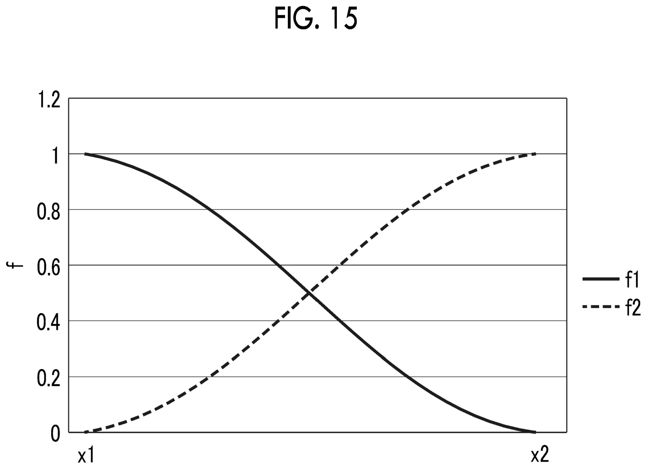

Data A3 illustrated in FIG. 14 is data that is a result of multiplying the data A2 by a Hanning window function f1. FIG. 15 is a graph illustrating the Hanning window function. As illustrated in FIG. 15, the Hanning window function f1 has a value of "1" at the position x1, the value gradually increases as the distance from the position x2 decreases, and the value reaches "0" at the position x2. That is, the Hanning window function f1 is a function that converges from x1 to x2.

Data B0 illustrated in FIG. 14 is data of the k-space that is a result of performing the edge enhancement processing on the CNN estimation image before a Fourier transform of the data A0 and performing a Fourier transform. The data B0 includes data B1 and data B2. The data B1 is data other than the data of the adjacent region in the data of the unmeasured region. The data B2 is data of the adjacent region.

Data B3 illustrated in FIG. 14 is data that is a result of multiplying the data B2 by a Hanning window function f2. As illustrated in FIG. 15, the Hanning window function f2 has a value of "0" at the position x1, the value gradually increases as the distance from the position x2 decreases, and the value reaches "1" at the position x2. That is, the Hanning window function f2 is a function that converges from x2 to x1.

Data C1 illustrated in FIG. 14 is data that is a result of adding the data A3 and the data B3.

Data C0 illustrated in FIG. 14 is data of the k-space that is a result of combining the data A1, the data C1, and the data B1. In the data C0, the data A1 of the measurement region to which the edge enhancement filter is not applied and the data B1 of the unmeasured region to which the edge enhancement filter is applied are smoothly connected through the data C1 of the adjacent region in which the intensity of the edge enhancement gradually changes.

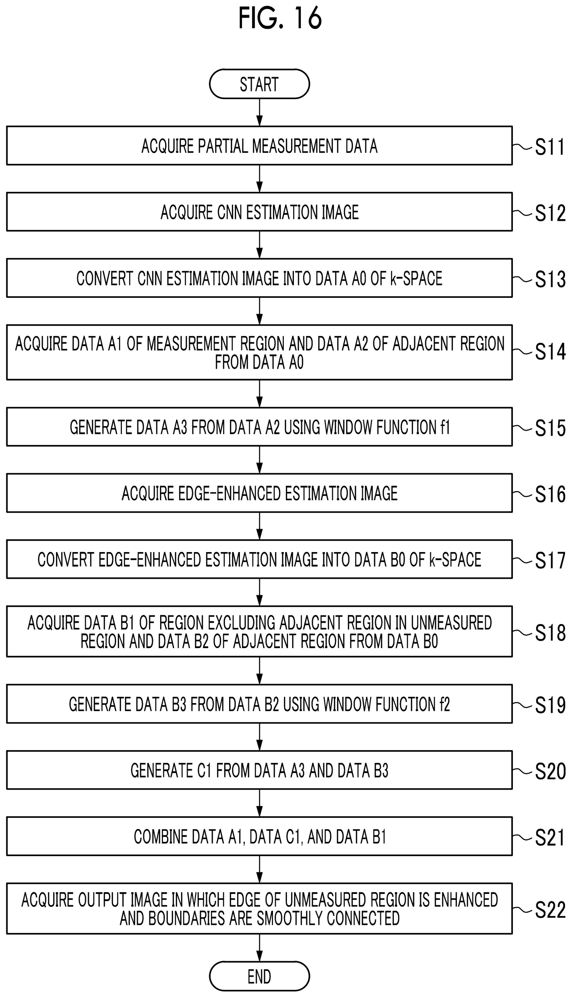

FIG. 16 is a flowchart illustrating steps of the generation method of the MR image according to the second embodiment. The processing of steps S11 and S12 is the same as the processing of steps S1 and S2 illustrated in FIG. 12.

In step S13, the processor 202 converts the CNN estimation image acquired in step S12 into the data A0 of the k-space. Here, the Fourier transform unit 238 performs a Fourier transform on the CNN estimation image to convert the CNN estimation image into the data A0 of the k-space.

In step S14, the processor 202 acquires the data A1 of the measurement region and the data A2 of the adjacent region from the data A0 of the k-space converted in step S13. Here, the combination processing unit 240 acquires, as the data A1, the entire data of the measurement region in the data A0 of the k-space converted in step S13. In addition, the combination processing unit 240 acquires the entire data of the adjacent region that is adjacent to the measurement region and is within a predetermined distance from the measurement region in the data of the unmeasured region (an example of "second unmeasured region data") from the data A0 of the k-space converted in step S13 as the data A2 (an example of "first adjacent region data"). The adjacent region is a region from the position x1 of the boundary between the measurement region and the unmeasured region to the position x2 that is 5% of the data size in the x direction away from the position x1. A width of the adjacent region in the x direction is not limited to 5% of the data size, and can be determined as appropriate.

In step S15, the processor 202 generates the data A3 in which the weight of the data A2 is gradually decreased as a distance from the measurement region increases. Here, the combination processing unit 240 multiplies the data A2 by the Hanning window function f1 (an example of a "first window function", see FIG. 15) to generate the data A3.

In step S16, the processor 202 acquires the edge enhancement estimation image. Here, the edge enhancement filter processing unit 242 performs the edge enhancement filter processing on the CNN estimation image acquired in step S12 to generate the edge enhancement estimation image.

In step S17, the processor 202 converts the edge enhancement estimation image acquired in step S16 into the data B0 of the k-space. Here, the Fourier transform unit 238 performs a Fourier transform on the edge enhancement estimation image to convert the edge enhancement estimation image into the data B0 of the k-space.

In step S18, the processor 202 acquires the data B1 of the region excluding the adjacent region in the unmeasured region and the data B2 of the adjacent region from the data B0 of the k-space converted in step S17. Here, the combination processing unit 240 acquires the entire data of the region excluding the adjacent region in the unmeasured region in the data B0 of the k-space converted in step S17, as the data B1 (an example of "first unmeasured region data other than the adjacent region"). In addition, the combination processing unit 240 acquires the entire data of the adjacent region in the data B0 of the k-space converted in step S17, as the data B2 (an example of "second adjacent region data").

In step S19, the processor 202 generates the data B3 in which the weight of the data B2 is gradually increased as a distance from the measurement region increases. Here, the combination processing unit 240 multiplies the data B2 by the Hanning window function f2 (an example of a "second window function", see FIG. 15) to generate the data B3.

In step S20, the processor 202 generates the data C1 from the data A3 and the data B3. Here, the combination processing unit 240 adds the data A3 and the data B3 to generate the data C1 (an example of "third adjacent region data").

In step S21, the processor 202 generates the data of the k-space in which the data A1 acquired in step S14, the data C1 generated in step S20, and the data B1 acquired in step S18 are combined. Here, the combination processing unit 240 generates the data of the k-space by filling the measurement region of the k-space with the data A1, filling the adjacent region of the k-space with the data C1, and filling the unmeasured region of the k-space excluding the adjacent region with the data B1. In the data of the k-space, the data of the measurement region in which the increase in noise is suppressed and the data of the unmeasured region in which the edges are enhanced and the resolution is improved are smoothly connected through the data of the adjacent region in which the intensity of the edge enhancement gradually changes.

Finally, in step S22, the processor 202 acquires the output image in which the edge of the data of the unmeasured region is enhanced and the boundaries are smoothly connected. Here, the inverse Fourier transform unit 234 performs an inverse Fourier transform on the data of the k-space acquired in step S21 to reconstruct the MR image that is the output image. In the MR image acquired in this way, the increase in noise of the data of the measurement region is suppressed, the resolution of the data of the unmeasured region is improved, and the measurement region and the unmeasured region are smoothly connected by the data of the adjacent region. As described above, with the generation method of the MR image according to the second embodiment, it is possible to generate the MR image in which the boundary between the measurement region and the unmeasured region is inconspicuous.

### Processor

In the present embodiment, each processing is executed by any computer. Further, any computer may execute the processing by a processor, a program, or a combination thereof. Any computer may be a general-purpose computer, a computer for a specific purpose, a system such as a workstation, or other hardware components capable of executing a program.

The processor may be configured by one or a plurality of hardware components, and the types of hardware are not limited. The processor may be configured by, for example, a central processing unit (CPU), a micro processing unit (MPU), a programmable logic device such as a field programmable gate array (FPGA), a dedicated circuit for executing specific processing, such as an application specific integrated circuit (ASIC), or hardware such as a graphics processing unit (GPU) or a neural processing unit (NPU).

Also, the processor includes each unit or each means that executes various types of processing in the present embodiment. The type of hardware may be a combination of different types of hardware components. In a case in which the plurality of types of hardware components are configured to execute one or a plurality of processes of a certain processor, the plurality of types of hardware components may be present in devices physically separated from each other or may be present in the same device. Furthermore, in any of the embodiments, the order of each process performed by the processor is not limited to the above-described order, and may be changed as appropriate. The hardware is configured by an electric circuit (circuitry) in which circuit elements, such as semiconductor elements, are combined, or the like.

Further, the present embodiment may be implemented by hardware, software, firmware, microcode, or a combination thereof. Software, firmware, and microcode are configured by a program. The program may be, for example, a group of program modules, and each function thereof may be implemented by a processor configured to execute each function. The program may be a program code or a plurality of code segments stored in one or more non-transitory computer-readable media (for example, a storage medium and other storages). The program may be stored in the plurality of non-transitory computer-readable media present in devices physically separated from each other. The program code or the code segment may represent any combination of procedures, functions, subprograms, routines, subroutines, modules, software packages, classes, or commands, data structures, or program statements. The program code or the code segment may be connected to another code segment or a hardware circuit by transmitting and receiving information, data, an argument, a parameter, or a content of a memory.

### Application Example to Program and Program Product

The generation method of the MR image according to the embodiment may be configured as a program or a program product that causes a processor or a computer including the processor to implement each function of the steps. The program product is a computer-readable medium that is a tangible, non-transitory information storage medium on which a program is recorded.

It is possible to record a program causing a computer to implement some or all of the processing functions of the MRI apparatus 10, on an optical disk, a magnetic disk, or a computer-readable medium such as a semiconductor memory or other tangible non-transitory storage medium, and to provide the program through this storage medium.

Alternatively to the aspect of providing the program stored on such a tangible, non-transitory computer-readable medium, the program signal may be provided as a download service via a communication network such as the Internet.

Further, some or all of the processing functions in the MRI apparatus 10 may be implemented by cloud computing, or can be provided as software as a service (SaaS).

### Others

With the edge enhancement filter processing according to the present disclosure, the resolution of the MR image is improved by enhancing the high-frequency components, and the visual resolution can be improved.

The technical scope of the present invention is not limited to the scope described in the embodiments described above. The configurations and the like in the respective embodiments can be appropriately combined between the respective embodiments without departing from the scope of the present invention.

### Explanation of References

10: MRI apparatus
12: gantry
100: measurement unit
102: subject
103: bed
104: static field magnet
106: gradient coil
108: RF coil
110: receive coil
112: radio frequency magnetic field generator
114: gradient magnetic field power supply
116: receiver
118: sequencer
200: control device
202: processor
204: memory
205: storage
206: input/output interface
208: display
210: operation unit
220: measurement controller
230: image calculation unit
232: k-space data generation unit
234: inverse Fourier transform unit
236: CNN estimation unit
238: Fourier transform unit
240: combination processing unit
242: edge enhancement filter processing unit
250: display controller
260: recording controller
add1: addition layer
Conv1 to 9: convolutional layer
f1: Hanning window function
f2: Hanning window function
F2A: full measurement data
F2B: image
F4A: k-space
F4B: k-space
F4C: k-space
F4D: k-space
F7A: complex image
F7B: complex image
F8A: image generation process
F8B: image generation process
F8C: image generation process
F8D: image generation process
F10A: MR image
F10B: MR image
F11A: CNN estimation image
F11B: data of k-space
F11C: edge enhancement estimation image
F11D: data of k-space
F11E: data of k-space
F11F: MR image
F13A: MR image
F13B: MR image
FKt: full measurement data
Fmt: full measurement image
in1: input layer
Pmu: partial measurement image
Pkt: partial measurement data
PKt: partial measurement data
Pmt: partial measurement image
PPmu: estimation image
Relu1 to Relu8: activation layer
S1 to S9: step of generation method of MR image
S11 to S22: step of generation method of MR image
x1: position
x2: position

## Claims

1. A magnetic resonance imaging apparatus (10) comprising:
a processor (202) that converts data acquired by imaging a subject (102) into an image,
wherein the processor (202)
acquires partial measurement data of an asymmetrical measurement region of a k-space,
reconstructs data of the k-space including the partial measurement data to generate a first reconstruction image of a real space,
estimates a second reconstruction image by inputting the first reconstruction image to a trained model that has been trained to receive an input of an input image in which the data of the k-space including data of the measurement region is reconstructed and output an estimation image in which data of an unmeasured region other than the measurement region is estimated,
acquires first measurement region data of the measurement region of the k-space obtained by performing a Fourier transform on the second reconstruction image,
generates a third reconstruction image obtained by performing edge enhancement filter processing on the second reconstruction image,
acquires first unmeasured region data of the unmeasured region of the k-space obtained by performing a Fourier transform on the third reconstruction image, and
generates a fourth reconstruction image by reconstructing the data of the k-space including the first measurement region data and the first unmeasured region data.

2. The magnetic resonance imaging apparatus (10) according to claim 1,
wherein the processor (202)
acquires first adjacent region data corresponding to an adjacent region that is adjacent to the measurement region and extends a predetermined distance from the measurement region in second unmeasured region data of the unmeasured region of the k-space obtained by performing a Fourier transform on the second reconstruction image,
acquires second adjacent region data corresponding to the adjacent region in the first unmeasured region data,
generates third adjacent region data from the first adjacent region data of which a weight is gradually decreased as a distance from the measurement region increases and the second adjacent region data of which a weight is gradually increased as the distance from the measurement region increases, and
generates the fourth reconstruction image by reconstructing the data of the k-space including the first measurement region data, the third adjacent region data, and the first unmeasured region data other than the adjacent region.

3. The magnetic resonance imaging apparatus (10) according to claim 2,
wherein the processor (202)
multiplies the first adjacent region data by a first window function having a value of 1 at a position adjacent to the measurement region and a value of 0 at a position at the predetermined distance from the measurement region,
multiplies the second adjacent region data by a second window function having a value of 0 at a position adjacent to the measurement region and a value of 1 at a position at the predetermined distance from the measurement region, and
generates the third adjacent region data by adding the multiplied first adjacent region data and the multiplied second adjacent region data.

4. The magnetic resonance imaging apparatus (10) according to claim 3,
wherein the first window function and the second window function are each a Hanning window.

5. The magnetic resonance imaging apparatus (10) according to any one of claims 1 to 4,
wherein the processor (202)
acquires strength of the edge enhancement filter processing, and
generates the third reconstruction image obtained by performing the edge enhancement filter processing with the acquired strength.

6. The magnetic resonance imaging apparatus (10) according to claim 5,
wherein the processor (202) acquires the strength based on an average value of absolute values of the data of the measurement region that is symmetrical to the unmeasured region of the k-space in the first measurement region data and an average value of absolute values of the first unmeasured region data.

7. The magnetic resonance imaging apparatus (10) according to claim 5,
wherein the processor (202) receives an input of the strength from an operator.

8. The magnetic resonance imaging apparatus (10) according to any one of claims 1 to 7,
wherein the trained model is a trained model that has been trained through machine learning to receive the input of the input image in which the data of the k-space consisting of the measurement region filled with input measurement region data and the unmeasured region filled with zero data is reconstructed, and estimate and output the estimated reconstruction image of the real space reconstructed from the data of the k-space consisting of the measurement region filled with estimated measurement region data and the unmeasured region filled with estimated unmeasured region data.

9. The magnetic resonance imaging apparatus (10) according to any one of claims 1 to 7,
wherein the trained model is a trained model that has been trained through machine learning to receive the input of the input image in which the data of the k-space consisting of the measurement region filled with input measurement region data and the unmeasured region filled with zero data is reconstructed, and estimate and output an estimated residual image indicating a residual between the input image and the estimated reconstruction image of the real space reconstructed from the data of the k-space consisting of the measurement region filled with estimated measurement region data and the unmeasured region filled with estimated unmeasured region data.

10. An image processing method executed by a processor (202) that converts data acquired by imaging a subject (102) into an image, the image processing method comprising:
acquiring partial measurement data of an asymmetrical measurement region of a k-space;
reconstructing data of the k-space including the partial measurement data to generate a first reconstruction image of a real space;
estimating a second reconstruction image by inputting the first reconstruction image to a trained model that has been trained to receive an input of an input image in which the data of the k-space including data of the measurement region is reconstructed and output an estimation image in which data of an unmeasured region other than the measurement region is estimated;
acquiring first measurement region data of the measurement region of the k-space obtained by performing a Fourier transform on the second reconstruction image;
generating a third reconstruction image obtained by performing edge enhancement filter processing on the second reconstruction image;
acquiring first unmeasured region data of the unmeasured region of the k-space obtained by performing a Fourier transform on the third reconstruction image; and
generating a fourth reconstruction image by reconstructing the data of the k-space including the first measurement region data and the first unmeasured region data.

11. A non-transitory computer-readable recording medium on which a program for causing a computer to execute the image processing method according to claim 10 is recorded.
